# EUROPÄISCHE PATENTSCHRIFT

(11) **EP 3 457 159 B1**
(45) Veröffentlichungstag und Bekanntmachung des Hinweises auf die Patenterteilung: **06.11.2024**
(21) Anmeldenummer: 17191849.3
(22) Anmeldetag: 19.09.2017
(51) Int. Cl.: G01R 33/48, G01R 33/56, G01R 33/50

(54) **VERBESSERTES MAGNETRESONANZ-FINGERPRINTING-VERFAHREN**
IMPROVED MAGNETIC RESONANCE FINGERPRINTING METHOD
PROCÉDÉ DE PRISE D'EMPREINTES PAR RÉSONANCE MAGNÉTIQUE AMÉLIORÉ

(43) Veröffentlichungstag der Anmeldung: 20.03.2019
(73) Patentinhaber: Siemens Healthineers AG, 91301 Forchheim (DE)
(72) Erfinder: Pfeuffer, Josef, 91358 Kunreuth (DE)
(74) Vertreter: Siemens Healthineers Patent Attorneys

(56) Entgegenhaltungen:
- DE-A1- 102012 222 149
- DE-A1- 102014 203 067
- DE-A1- 102014 203 068
- US-A1- 2009 069 664
- US-A1- 2016 341 807
- US-A1- 2017 139 025
- US-A1- 2017 234 951
- FLASSBECK S ET AL: "Quantification of Flow by Magnetic Resonance Fingerprinting", PROCEEDINGS OF THE INTERNATIONAL SOCIETY FOR MAGNETIC RESONANCE IN MEDICINE, ISMRM, 25TH ANNUAL MEETING AND EXHIBITION, HONOLULU, HAWAII, USA, 22-27 APRIL 2017, no. 128, 7 April 2017 (2017-04-07), XP040687696

## Beschreibung

Die Erfindung betrifft eine Verbesserung von Magnetresonanz-Fingerprinting-Verfahren.

Die Magnetresonanz-Technik (im Folgenden steht die Abkürzung MR für Magnetresonanz) ist eine bekannte Technik, mit der Bilder vom Inneren eines Untersuchungsobjektes erzeugt werden können. Vereinfacht ausgedrückt wird hierzu das Untersuchungsobjekt in einer Magnetresonanzanlage in einem vergleichsweise starken statischen, homogenen Grundmagnetfeld, auch B₀-Feld genannt, mit Feldstärken von 0,2 Tesla bis 7 Tesla und mehr positioniert, so dass sich dessen Kernspins entlang des Grundmagnetfeldes orientieren. Zum Auslösen von Kernspinresonanzen werden hochfrequente Anregungspulse (RF-Pulse) in das Untersuchungsobjekt eingestrahlt, die ausgelösten Kernspinresonanzen als sogenannte k-Raumdaten gemessen und auf deren Basis MR-Bilder rekonstruiert oder Spektroskopiedaten ermittelt. Zur Ortskodierung der Messdaten werden dem Grundmagnetfeld schnell geschaltete magnetische Gradientenfelder überlagert. Die aufgezeichneten Messdaten werden digitalisiert und als komplexe Zahlenwerte in einer k-Raum-Matrix abgelegt. Aus der mit Werten belegten k-Raum-Matrix ist z.B. mittels einer mehrdimensionalen Fourier-Transformation ein zugehöriges MR-Bild rekonstruierbar.

Eine Magnetresonanz-Bildgebung mittels einer Magnetresonanzanlage kann dazu dienen, eine Anwesenheit und/oder eine Verteilung eines Stoffs, welcher sich in einem Untersuchungsobjekt befindet, zu bestimmen. Der Stoff kann dabei beispielsweise ein, möglicherweise pathologisches, Gewebe des Untersuchungsobjekts, ein Kontrastmittel, eine Markierungssubstanz oder ein Stoffwechselprodukt sein. Informationen über die vorliegenden Stoffe können dabei auf vielfältige Weise aus den aufgenommenen Messdaten gewonnen werden. Eine relativ einfache Informationsquelle sind z.B. aus den Messdaten rekonstruierte Bilddaten. Es gibt jedoch auch komplexere Verfahren, die, z.B. aus Bildpunkt-Zeit-Serien von aus sukzessive gemessenen Messdatensätzen rekonstruierten Bilddaten, Informationen über das untersuchte Untersuchungsobjekt ermitteln.

Zu derartigen Verfahren gehören beispielsweise Magnetresonanz-Fingerprinting-Verfahren (MRF-Verfahren), bei denen Signalverläufe von aus zeitlich nacheinander mit verschiedenen Aufnahmeparametern, den "Fingerprinting-Parametern", aufgenommenen Messdaten rekonstruierten Bilddaten mittels Mustererkennungsverfahren ("pattern recognition") mit Signalverläufen einer zuvor ermittelten Datenbank von für bestimmte Stoffe charakteristischen Signalverläufen ("dictionary") verglichen werden, um die in den aus den Messdaten rekonstruierten Bilddaten repräsentierten Stoffe bzw. die räumliche Verteilung von gewebespezifischen Parametern (wie die Transversalrelaxation T2 oder die Longitudinalrelaxation T1; sogenannte T1- und T2-Karten) in dem abgebildeten Untersuchungsobjekt zu ermitteln.

Magnetresonanz-Fingerprinting-Verfahren sind beispielsweise in dem Artikel von Ma et al., "Magnetic Resonance Fingerprinting", Nature, 495: S. 187-192 (2013), dem Artikel von Jiang et al., ""MR Fingerprinting Using Fast Imaging with Steady State Precession (FISP) with Spiral Readout", Magnetic Resonance in Medicine 74: S. 1621-1631 (2015) oder auch dem Artikel von Cloos et al. "Online Radial Multiband Magnetic Resonance Fingerprinting", ISMRM 2016: S. 608 bekannt.

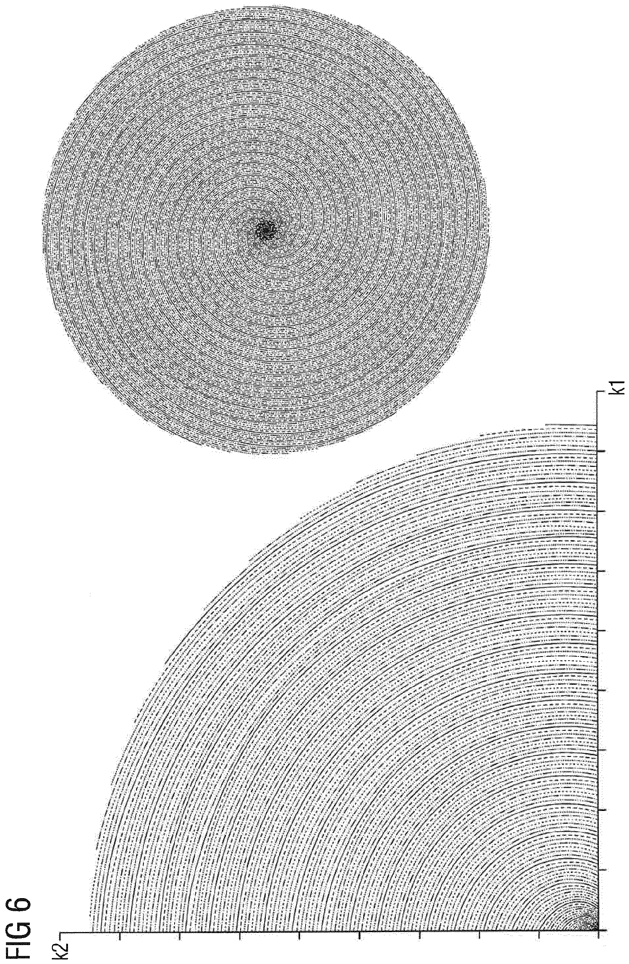

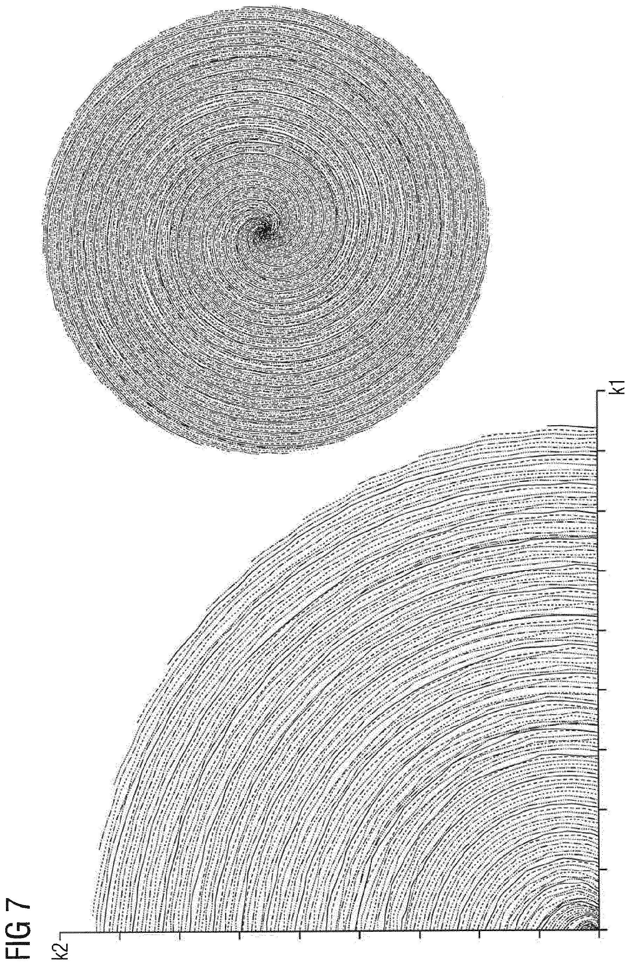

In dem genannten Artikel von Jiang et al. wird ein MRF-Verfahren beschrieben, bei dem eine FISP ("Fast Imaging with Steady State Precession")-Sequenz verwendet wird, die 1000 Mal unter Variation der Wiederholzeit TR und des Flipwinkels wiederholt wird, wobei bei jeder Wiederholung Messdaten entlang einer spiralförmigen k-Raum-Trajektorie aufgenommen werden. In dem beschriebenen Verfahren werden 24 Wiederholungen benötigt, um das k-Raum-Zentrum mit der k-Raum-Trajektorie gemäß Nyquist vollständig abzutasten und sogar 48 Wiederholungen, um insgesamt eine Auflösung von 256*256 zu erreichen, bei der auch der periphere k-Raumbereich gemäß Nyquist vollständig abgetastet ist. Die verwendete k-Raum-Trajektorie wird daher in jeder Wiederholung um einen Winkelschritt von 360°/48 = 7,5° rotiert. Ein Messdatensatz einer Wiederholung, aus dem Bilddaten rekonstruiert werden, ist somit 48-fach unterabgetastet. Daher weisen die rekonstruierten Bilddaten, aus denen die mit der Datenbank zu vergleichenden Bildpunkt-Zeit-Serien erstellt werden, starke Unterabtastungs-Artefakte auf (vgl. Figuren 6d oder 7a in Jiang et al.). Obwohl Jiang et al. in dem Artikel schließen, dass diese Unterabtastungs-Artefakte sich insgesamt herausmitteln und daher keinen Einfluss auf die Parameterkarten haben, die als Ergebnisse des Vergleichs mit der Datenbank erhalten werden, können doch räumliche fehlerhafte Abweichungen /Verschiebungen ("spatial bias"), die auch als Shading-Artefakte bezeichnet werden, in den Parameterkarten auftreten (vgl. Figur 7b in Jiang et al.).

Der Artikel von Flassbeck et al. "Quantification of Flow by Magnetic Resonance Fingerprinting", Proc. Int. Soc. Magn. Reson. Med. 2017, S. 128 beschreibt ein Verfahren zur Flussquantifizierung mittels MRF.

In dem Artikel von Pfeuffer et al. "Mitigation of Spiral Undersampling Artifacts in Magnetic Resonance Fingerprinting (MRF) by Adapted Interleave Reordering", Proc. Int. Soc. Magn. Reson. Med., 2017, 133, sowie in der nachveröffentlichten EP17185874 wird bereits ein Verfahren beschrieben, bei dem die Reihenfolge der k-Raumtrajektorien, entlang derer in aufeinanderfolgenden Wiederholungen Messdaten aufgenommen werden, optimiert wird, um störende Artefakte in aus den Messdaten einer Wiederholung rekonstruierten Bilddaten zu vermeiden oder zu reduzieren. Durch die Optimierung der Reihenfolge, in welcher die k-Raumtrajektorien abgetastet werden, wird ein zeitlicher Mittelungseffekt erreicht, der bereits die ungewünschten Artefakte reduziert. Die Optimierung ist jedoch aufwändig, da weitere Effekte wie z.B. das jeweilige Design der k-Raumtrajektorie, die Abtastdichte und auch MRF-spezifische Parameter (gewählte Flipwinkel, Wiederholungszeiten,...) eine Rolle spielen können.

Der Erfindung liegt die Aufgabe zugrunde, Artefakte in mittels MRF-Verfahren gewonnenen Datensätzen zu vermeiden.

Die Aufgabe wird gelöst durch ein Magnetresonanz-Fingerprinting-Verfahren zur Erzeugung von Messdaten eines Untersuchungsobjektes gemäß Anspruch 1, eine Magnetresonanzanlage gemäß Anspruch 9, ein Computerprogramm gemäß Anspruch 10 sowie einen elektronisch lesbaren Datenträger gemäß Anspruch 11.

Ein erfindungsgemäßes Magnetresonanz-Fingerprinting-Verfahren zur Erzeugung von Messdaten eines Untersuchungsobjektes umfasst die Schritte:
- Laden von Parametern, die eine Start-k-Raumtrajektorie beschreiben, entlang der Messdaten aufgenommen werden sollen,
- Erstellen mindestens einer Mess-k-Raumtrajektorie durch Fluktuieren mindestens eines den Verlauf der Start-k-Raumtrajektorie bestimmenden Parameters, sodass die erstellte Mess-k-Raumtrajektorie (MkRt) erratisch verläuft,
- Aufnehmen von Messdaten entlang der Mess-k-Raumtrajektorie,
- Wiederholen der Aufnahme von Messdaten entlang von erstellten Mess-k-Raumtrajektorien mit unterschiedlichen Fingerprinting-Parametern bis alle gewünschten Messdaten aufgenommen sind,
- Speichern der aufgenommenen Messdaten in einem Messdatensatz,
wobei das Fluktuieren derart erfolgt, dass eine räumliche und/oder zeitliche Verteilung des in den aufgenommenen Signalen enthaltenen Rauschens möglichst homogen ist.

Der Erfindung liegt die Erkenntnis zugrunde, dass auch ein MRF-Zielsignal eines Bildpunktes, d.h. das Ergebnis des Vergleichs mit den charakteristischen Signalverläufen, immer von zusätzlichen Signalen überlagert ist, und damit mit Rauschen behaftet ist. Die zusätzlichen Signale stammen hierbei jeweils aus allen anderen Bildpunkten des aufgenommenen Bildes, und dass diese zusätzlichen Signale nicht zufällig, sondern kohärent, sind, und sich mit jeder Wiederholung der Abtastung einer k-Raumtrajektorie abhängig von der k-Raumtrajektorie (z.B. abhängig von dem jeweiligen Rotationswinkel) ändern. Diese Kohärenzen führen zu systematischen Fehlern und verzerrten MRF-Ergebnissen, die sich als Artefakte, manchmal Einfaltungsartefakte genannt, darstellen.

Durch das Fluktuieren des mindestens einen den Verlauf der Start-k-Raumtrajektorie im k-Raum bestimmenden Parameters wird erreicht, dass auch die erstellte Mess-k-Raumtrajektorie selbst im k-Raum nicht mehr einem stringenten Pfad folgt, sondern erratisch verläuft. Die Aufnahme von Messdaten entlang von derartig schlingernd verlaufenden Mess-k-Raumtrajektorien erzeugt inkohärentes Rauschen in den aufgenommenen Signalen und vermeidet somit die oben genannten systematischen Fehler, Verzerrungen und Artefakte in mittels MRF erhaltenen Ergebnissen, wie z.B. Karten von Zerfallskonstanten.

Das Fluktuieren des mindestens einen Parameters, aus einer Gruppe von Parametern, die den Verlauf der k-Raumtrajektorie bestimmen, kann insbesondere durch zufälliges variieren des jeweiligen Parameters, insbesondere innerhalb von vorgegebenen Grenzwerten, erfolgen. Die zufällige Variation sorgt für einen ausreichend erratischen Verlauf. Die Vorgabe von Grenzwerten, innerhalb derer die Parameter trotz der Fluktuation liegen sollen, gewährt eine bessere Kontrolle z.B. auch hinsichtlich einer Ausführbarkeit der erhaltenen Mess-k-Raumtrajektorien.

Als Parameter dieser Gruppe kommen insbesondere die Amplituden der verwendeten Gradienten, die Anstiegsraten (Slewrates) der verwendeten Gradienten, sowie auch ggf. hiervon abhängige Parameter wie Startposition einer Start-k-Raumtrajektorie oder Startwinkel für radiale oder spiralförmige Start-k-Raumtrajektorien oder der Verlauf des Radius einer spiralförmigen Start-k-Raumtrajektorie, insbesondere jeweils im Verlauf der Zeit, in Betracht.

Das Fluktuieren erfolgt derart, dass eine räumliche und/oder zeitliche Verteilung des in den aufgenommenen Signalen enthaltenen Rauschens möglichst homogen ist.

Dazu können beispielsweise Rahmenbedingungen (z.B. Grenzwerte beim Fluktuieren) für das Fluktuieren der zu fluktuierenden Parameter derart optimiert gewählt werden, dass eine gewünschte Homogenität der räumlichen und/oder zeitlichen Verteilung des in den aufgenommenen Signalen enthaltenen Rauschens erreicht wird, wodurch Unterabtastungs-Artefakte in aus den Messdaten rekonstruierten Bilddaten reduziert werden. Als weitere Kriterien bei der optimierten Wahl von Rahmenbedingungen können z.B. eine für eine erhaltene Mess-k-Raumtrajektorie notwendige Messzeit und/oder auch Hardwarebeschränkungen sein. Beispielsweise können durch das Fluktuieren verursachte große Schwankungen in der Amplitude eines für eine Mess-k-Raumtrajektorie zu schaltenden Gradienten dazu führen, dass sich die Messzeit verlängert. Auf der anderen Seite ist eine gewisse Schwankung in dem Parameter ja gerade gewünscht. Daher kann es sinnvoll sein, Minimal- und/oder Maximalwerte für die Fluktuation der Parameter vorzugeben oder derart zu ermitteln, dass aus den entlang der Mess-k-Raumtrajektorien aufgenommenen Messdaten möglichst artefaktfreie Bilddaten rekonstruiert werden können. Dabei können verschiedene Kriterien berücksichtigt werden. Beispielsweise kann eine nur geringe Fluktuation eines zu fluktuierenden Parameters, und damit eine geringe räumliche Umverteilung von in den aufgenommenen Messdaten enthaltenem Rauschen bereits zu befriedigenden Ergebnissen führen, wenn die zeitliche Verteilung des Rauschens, z.B. durch verschiedene Fluktuationen in verschiedenen Wiederholungen, ausreichend ungleichmäßig ist.

Eine erfindungsgemäße Magnetresonanzanlage umfasst eine Magneteinheit, eine Gradienteneinheit, eine Hochfrequenzeinheit und eine zur Durchführung eines erfindungsgemäßen Verfahrens ausgebildete Steuereinrichtung mit einer Hochfrequenz-Sende-/Empfangs-Steuerung und einer Fluktuierungseinheit.

Ein erfindungsgemäßes Computerprogramm implementiert ein erfindungsgemäßes Verfahren auf einer Steuereinrichtung, wenn es auf der Steuereinrichtung ausgeführt wird.

Das Computerprogramm kann hierbei auch in Form eines Computerprogrammprodukts vorliegen, welches direkt in einen Speicher einer Steuereinrichtung ladbar ist, mit Programmcode-Mitteln, um ein erfindungsgemäßes Verfahren auszuführen, wenn das Computerprogrammprodukt in der Recheneinheit des Rechensystems ausgeführt wird.

Ein erfindungsgemäßer elektronisch lesbarer Datenträger umfasst darauf gespeicherte elektronisch lesbare Steuerinformationen, welche zumindest ein erfindungsgemäßes Computerprogramm umfassen und derart ausgestaltet sind, dass sie bei Verwendung des Datenträgers in einer Steuereinrichtung einer Magnetresonanzanlage ein erfindungsgemäßes Verfahren durchführen.

Die in Bezug auf das Verfahren angegebenen Vorteile und Ausführungen gelten analog auch für die Magnetresonanzanlage, das Computerprogrammprodukt und den elektronisch lesbaren Datenträger.

Weitere Vorteile und Einzelheiten der vorliegenden Erfindung ergeben sich aus den im Folgenden beschriebenen Ausführungsbeispielen sowie anhand der Zeichnungen. Die aufgeführten Beispiele stellen keine Beschränkung der Erfindung dar. Es zeigen:
- Fig. 1: ein schematisches Ablaufdiagramm eines erfindungsgemäßen Verfahrens,
- Fig. 2: ein Beispiel für den zeitlichen Verlauf eines den Verlauf einer k-Raumtrajektorie bestimmenden Parameters,
- Fig. 3: ein Beispiel für den zeitlichen Verlauf eines den Verlauf einer k-Raumtrajektorie bestimmenden Parameters,
- Fig. 4: ein Beispiel eines Ergebnisses einer Fluktuation des Parameters aus Figur 2,
- Fig. 5: ein Beispiel eines Ergebnisses einer Fluktuation des Parameters aus Figur 3,
- Fig. 6: ein Beispiel eines Verlaufs von Start-k-Raumtrajektorien im k-Raum,
- Fig. 7: beispielhafte, ausgehend von den in Figur 6 gezeigten Start-k-Raumtrajektorien erstelle Mess-k-Raumtrajektorien,
- Fig. 8: eine schematisch dargestellte erfindungsgemäße Magnetresonanzanlage.

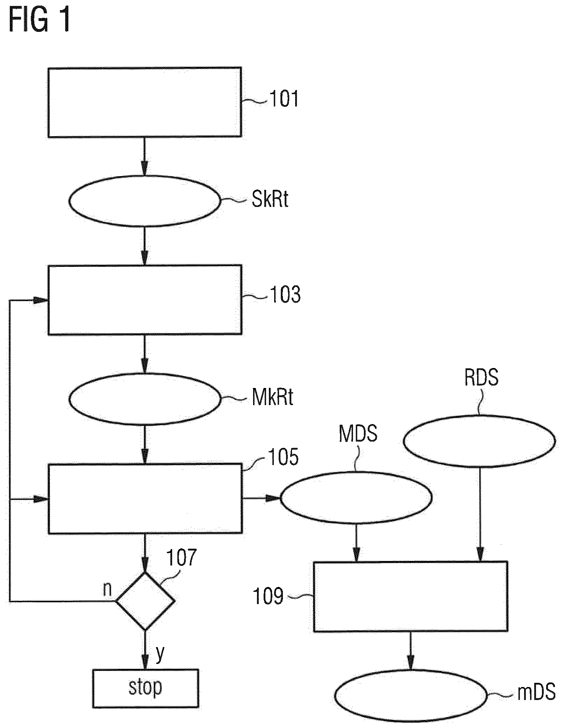

Figur 1 ist schematisches Ablaufdiagramm eines erfindungsgemäßen Verfahrens zur Erzeugung von Messdaten eines Untersuchungsobjektes mittels Magnetresonanz-Fingerprinting.

Dabei werden Parameter geladen, die eine Start-k-Raumtrajektorie SkRt beschreiben, entlang der erzeugte Echosignale als Messdaten MDS aufgenommen werden sollen (Block 101). Die geladenen Parameter enthalten somit Informationen über einzustrahlende RF-Pulse, zu schaltende Gradienten und Auslesezeiten in ihrer zeitlichen Abfolge und Relation zueinander.

Die über die Parameter beschriebene Start-k-Raumtrajektorie kann hierbei insbesondere eine kartesische k-Raumtrajektorie oder eine radiale oder spirale k-Raumtrajektorie sein.

Es ist möglich, nach nur einer Anregung von Echosignalen alle gewünschten Messdaten entlang nur einer k-Raumtrajektorie aufzunehmen (sogenannte "single-shot"-Verfahren). Häufig erfolgt die Aufnahme der Messdaten jedoch segmentiert, d.h. der abzutastende k-Raum wird in mehreren Schritten (sogenannte "multi-shot"-Verfahren) jeweils entlang geänderter k-Raumtrajektorien abgetastet. Bei einer derartigen segmentierten Aufnahme kann für jedes Segment eine Start-k-Raumtrajektorie SkRt vorgegeben sein. Es kann auch je eine Start-k-Raumtrajektorie SkRt für ein jeweiliges Segment beispielsweise durch Rotation und/oder Translation im k-Raum ausgehend von einer gemeinsamen Start-k-Raumtrajektorie SkRt bestimmt werden.

Insbesondere für segmentierte Aufnahmen von MR Messdaten können daher in Block 101 auch Parameter für mindestens zwei Start-k-Raumtrajektorien SkRt geladen werden, insbesondere Parameter für je eine Start-k-Raumtrajektorie SkRt je geplantem Segment.

Werden mindestens zwei Start-k-Raumtrajektorien SkRt geladen für die Mess-k-Raumtrajektorien MkRt erstellt werden sollen, entlang derer Messdaten aufgenommen werden sollen, kann eine einzelne Start-k-Raumtrajektorie SkRt derart gewählt sein, dass sie allein den k-Raum gemäß Nyquist nicht vollständig abtastet. Die geladenen Start-k-Raumtrajektorien können derart gewählt werden, dass sie zusammen den k-Raum mit einem gewünschten Grad der Vollständigkeit abtasten. Wird, beispielsweise um die Messzeit zu verkürzen, eine (weiterhin) insgesamt durch die geladenen Start-k-Raumtrajektorien SkRt nicht-vollständige Abtastung gewählt, können dann geeignete Ergänzungs-Verfahren, wie z.B. Partial-Fourier-Verfahren, Parallele Akquisitionsverfahren oder iterative Rekonstruktionsverfahren, bei der Rekonstruktion von Bilddaten aus den Messdaten MDS eingesetzt werden. Dies kann auch bei single-shot-Verfahren der Fall sein.

Für jede, gemäß der geladenen Parameter, geladene Start-k-Raumtrajektorie SkRt wird durch Fluktuieren mindestens eines den Verlauf der Start-k-Raumtrajektorie bestimmenden Parameters mindestens eine Mess-k-Raumtrajektorie MkRt erstellt (Block 103).

Durch das Fluktuieren weicht der Verlauf der Mess-k-Raumtrajektorie MkRt für aufeinanderfolgende Messpunkte jeweils in anderer Art und Weise von dem Verlauf der zugehörigen Start-k-Raumtrajektorie SkRt ab. Somit ändert sich durch das Fluktuieren nicht nur die Lage oder Position der Mess-k-Raumtrajektorie MkRt im Vergleich zu der zugehörigen Start-k-Raumtrajektorie SkRt, sondern es wird die Form derart verändert, dass die Mess-k-Raumtrajektorie MkRt im k-Raum nicht mehr wie die ursprüngliche Start-k-Raumtrajektorie SkRt einem stringenten Pfad folgt, sondern erratisch von der ursprünglichen Start-k-Raumtrajektorie SkRt abweicht.

Das Fluktuieren kann hierbei durch zufällige Variation des mindestens einen den Verlauf der k-Raumtrajektorie bestimmenden Parameters innerhalb vorgegebener Grenzwerte erfolgen.

Erfindungsgemäß erfolgt das Fluktuieren derart, dass eine räumliche und/oder zeitliche Verteilung des in den aufgenommenen Signalen enthaltenen Rauschens möglichst homogen ist. Dazu können z.B. Rahmenbedingungen für die Fluktuation vorgegeben werden, die erreichen, dass die jeweiligen Mess-k-Raumtrajektorien MkRt in aufeinanderfolgenden Aufnahmen von Messdaten derart fluktuiert und/oder zeitlich verteilt sind, dass in den Aufnahmen enthaltenes Rauschen möglichst inkohärent ist.

Derartige Rahmenbedingungen können hierbei auch beispielsweise zwischen den Extremen einer maximalen Inkohärenz (und damit minimalen Artefakten) einerseits und einer maximalen Qualität der erhaltenen MRF-Parameterkarten oder aus den Messdaten erstellter MR-Bilder oder einer minimalen Messzeit bzw. Akquisitionslänge andererseits abwägen und optimiert werden. Optimierungskriterien hierfür können anhand von aus (unterabgetasteten) Messdaten rekonstruierten MR-(Basis-)Bildern und/oder erhaltenen MRF-Parameterkarten bestimmt werden.

Der mindestens eine den Verlauf der k-Raumtrajektorie bestimmende Parameter, der fluktuiert wird, kann beispielsweise für radiale oder spirale Start-k-Raumtrajektorien der Startwinkel der Start-k-Raumtrajektorie sein, sodass die Mess-k-Raumtrajektorien auch "krumme" Startwinkel, die nicht z.B. linear von einer Anzahl an vorhandenen Start-k-Raumtrajektorien abhängen, und, die in herkömmlichen Verfahren als "Zwischenwinkel" nicht verwendet werden würden. Bei spiralen Start-k-Raumtrajektorien kann der mindestens eine den Verlauf der k-Raumtrajektorie bestimmende und zu fluktuierende Parameter zusätzlich oder alternativ der von der Amplitude der geschalteten Gradienten abhängige Radius (im zeitlichen Verlauf) der Start-k-Raumtrajektorie sein. Insbesondere bei kartesischen k-Raumtrajektorien kann der mindestens eine den Verlauf der k-Raumtrajektorie bestimmende Parameter, der fluktuiert wird, ein Parameter der geschalteten Gradienten sein, insbesondere deren Amplitude, der die Position eines Messpunktes im k-Raum bestimmt.

Bei wiederholten Aufnahmen von Messdaten im gewünschten k-Raum, beispielsweise für MRF-Verfahren, bei welchen für die Erstellung eines Fingerprint eine Vielzahl (bis zu mehrere hundert oder auch tausend) an Wiederholungen der Aufnahmen je abgetasteter k-Raumtrajektorie durchgeführt werden, können für jede Wiederholung einer Aufnahme entlang einer Start-k-Raumtrajektorie SkRt jeweils unterschiedliche Mess-k-Raumtrajektorien MkRt erstellt werden.

Somit können Messdaten MDS wiederholt in mindestens zwei Wiederholungen basierend auf einer Start-k-Raumtrajektorie SkRt aufgenommen werden, wobei für jede Wiederholung der Aufnahme der Messdaten MDS jeweils unterschiedliche Mess-k-Raumtrajektorien MkRt ausgehend von der Start-k-Raumtrajektorie SkRt erstellt werden. Durch eine derartige stete Fluktuation der k-Raumtrajektorien, entlang derer die Messdaten wiederholt aufgenommen werden, kann ein besonders hoher Grad an Inkohärenz in dem in den Messdaten enthaltenen Rauschen erreicht werden.

Es ist jedoch auch denkbar, dass zu jeder geladenen Start-k-Raumtrajektorie SkRt jeweils genau eine Mess-k-Raumtrajektorie erstellt wird. Eine Beschränkung der Fluktuation derart, dass für jede Start-k-Raumtrajektorie SkRt jeweils nur eine Mess-k-Raumtrajektorie MkRt erstellt wird, entlang welcher in jeder Wiederholung der MRF-Messung Messdaten aufgenommen werden, kann vorteilhaft für eine iterative Rekonstruktion und/oder Datenkomprimierung ("data compressibility") sein. Durch eine derartige Beschränkung der Fluktuation in der Zeitdomäne kann beispielsweise eine iterative Rekonstruktion bzw. eine Zeitdomänenkompression in Hauptkomponenten ggf. besser genutzt werden.

In jedem Fall werden entlang der erstellten Mess-k-Raumtrajektorien MkRt Messdaten MDS aufgenommen (Block 105), die in einem Messdatensatz gespeichert werden.

Wurden alle gewünschten Messdaten bereits aufgenommen (Abfrage 107, "y"), endet die Messung ("stop"). Wurden noch nicht alle gewünschten Messdaten MDS aufgenommen (Abfrage 107, "n"), wird die Aufnahme von Messdaten MDS entlang von erstellten Mess-k-Raumtrajektorien MkRt mit unterschiedlichen Fingerprinting-Parametern wiederholt. Wie oben bereits beschrieben können hierbei bereits erstellte Mess-k-Raumtrajektorien MkRt verwendet werden, oder basierend auf den geladenen Start-k-Raumtrajektorien SkRt durch erneutes Fluktuieren erneut Mess-k-Raumtrajektorien MkRt erstellt werden.

Die in dem Messdatensatz gespeicherten Messdaten MDS können mit einem Referenzdatensatz RDS, beispielsweise einem MRFdictionary, verglichen werden, um gewünschte Parameterkarten mDS zu erstellen (Block 109).

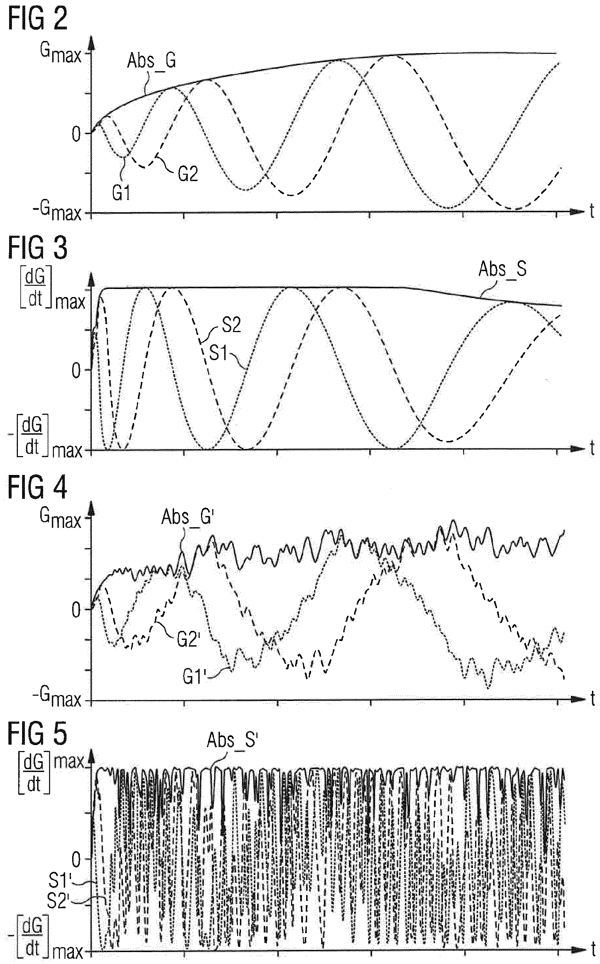

In Figur 2 ist ein Beispiel für den zeitlichen Verlauf eines den Verlauf einer k-Raumtrajektorie bestimmenden Parameters, hier der Amplitude der geschalteten Gradienten, dargestellt. In dem gezeigten Beispiel ist die Änderung der Amplitude über die Zeit t eines ersten zu schaltenden Gradienten G1, der in einer erste Richtung, z.B. in Ausleserichtung angelegt wird, und eines zweiten zu schaltenden Gradientn G2, der in eine zweite Richtung, z.B. in Phasenkodierrichtung, angelegt wird, die sich von der ersten Richtung unterscheidet, insbesondere senkrecht zu der ersten Richtung steht, dargestellt. Eine derartige Schaltung von Gradienten führt zu einer typischen zweidimensionalen (2D), stringenten, spiralen k-Raumtrajektorie, wie sie als Start-k-Raumtrajektorie verwendet werden kann. Weiterhin ist in Figur 2 der Absolutbetrag Abs_G beider Gradienten G1 und G2 eingezeichnet.

In Figur 3 sind die zu den Gradienten G1 und G2 gehörigen Anstiegsraten (Slewrates) S1 und S2 und ihr Absolutbetrag Abs_S dargestellt und somit ein weiteres (wenn auch von Figur 2 abhängiges) Beispiel für den zeitlichen Verlauf eines den Verlauf einer k-Raumtrajektorie bestimmenden Parameters. Die Anstiegsrate eines Gradienten ergibt sich durch Ableiten nach der Zeit.

Eine Darstellung mehrerer, hier 48, derartiger (2D in den k-Raumrichtungen k1 und k2 liegender) spiralförmiger (Start-)k-Raumtrajektorien, die jeweils durch Rotation ineinander überführt werden können, ist in Figur 6 gegeben, wobei die gesamten k-Raumtrajektorien rechts gezeigt sind, und, für bessere Sichtbarkeit, links ein vergrößerter Ausschnitt eines Quadranten desselben k-Raums. Derartige k-Raumtrajektorien, wie sie auch in dem genannten Artikel von Jiang et al. verwendet werden, können als Start-k-Raumtrajektorien für das hierin beschriebene Verfahren dienen.

In den Figuren 4, 5 und 7 sind beispielhaft Ergebnisse einer erfindungsgemäßen Fluktuation dargestellt

Figur 4 zeigt das Ergebnis einer Fluktuation der Amplituden der Gradienten G1 und G2 aus Figur 2. Aus dem Gradienten G1 wurde der um den Verlauf des Gradienten G1 schlingernde Gradient G1'. Aus dem Gradienten G2 wurde der um den Verlauf des Gradienten G2 schlingernde Gradient G2'. Auch der Absolutbetrag Abs_G' der beiden Gradienten G1' und G2` schwankt erratisch um den Verlauf des ursprünglichen Absolutbetrags Abs_G.

Wie in Figur 5 gezeigt, sind durch das Fluktuieren auch die jeweils zu den Gradienten G1' und G2` gehörenden Anstiegsraten S1 und S2', sowie deren Absolutbetrag Abs_S' stark erratisch im Vergleich zu dem ursprünglichen Verläufen in Figur 3. Bei der Fluktuation kann es somit sinnvoll sein, als Rahmenbedingung maximal mögliche Anstiegsraten und Umsschaltzeiten zu berücksichtigen.

Entsprechend Figur 6 sind in Figur 7 Darstellungen von Mess-k-Raumtrajektorien, wie sie beispielsweise nach Fluktuation von Parametern der Start-k-Raumtrajektorien aus Figur 6 erstellt worden sein können, einmal, links, in der Gesamtsicht, und einmal, rechts vergrößert, gezeigt.

Jede der 48 Start-k-Raumtrajektorien aus Figur 6 wurde auf eine eigene Art und Weise fluktuiert, sodass die k-Raumpunkte auf einer Mess-k-Raumtrajektorie, an denen nacheinander Messdaten aufgenommen werden, lokal variierende Abstände aufweisen und/oder das abgebildete Blickfeld ("field of view") variiert. Weiterhin wird durch eine unterschiedliche Fluktuation der jeweiligen Start-k-Raumtrajektorien erreicht, dass ein in entlang einer der Mess-k-Raumtrajektorien aufgenommenen Messdaten enthaltenes Rauschen jeweils anders räumlich verteilt ist. Dadurch werden systematische Fehler in aus den aufgenommenen Messdaten ermittelten Signalverläufen vermieden oder zumindest reduziert.

Wird die Aufnahme von Messdaten entlang von auf den beispielhaften 48 Start-k-Raumtrajektorien erstellten Mess-k-Raumtrajektorien mit unterschiedlichen Fingerprinting-Parametern wiederholt, kann weiterhin die Reihenfolge, in der die auf Basis der Start-k-Raumtrajektorien erstellten Mess-k-Raumtrajektorien nacheinander abgetastet werden derart optimiert werden, dass ein in den aufgenommenen Messdaten enthaltenes Rauschen auch zeitlich möglichst unterschiedlich verteilt ist. Somit kann das Fluktuieren der Start-k-Raumtrajektorien auch eine Optimierung der Reihenfolge der nacheinander abzutastenden Mess-k-Raumtrajektorien umfassen.

Eine Fluktuation von andersartigen Start-k-Raumtrajektorien, z.B. radialen oder kartesischen, kann analog erfolgen.

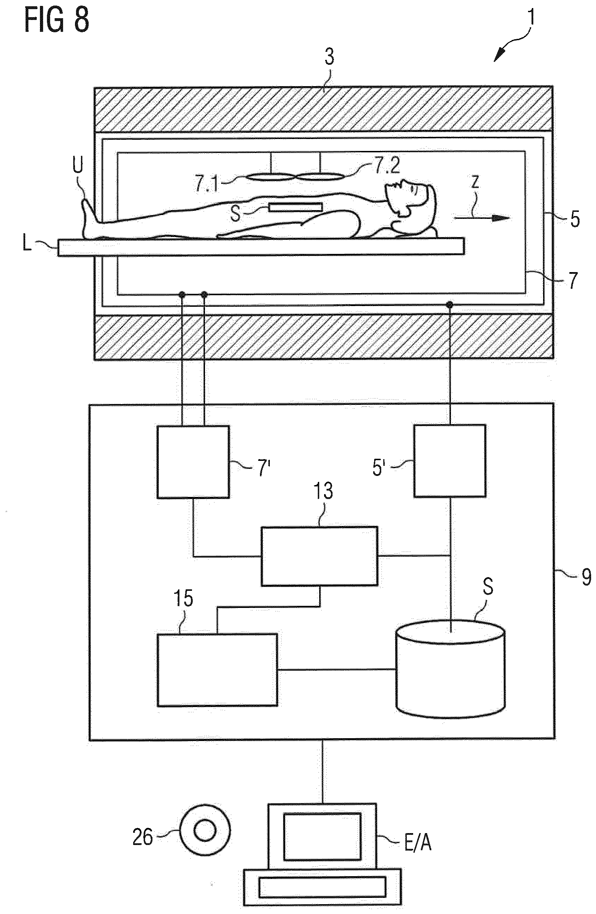

Figur 8 stellt schematisch eine erfindungsgemäße Magnetresonanzanlage 1 dar. Diese umfasst eine Magneteinheit 3 zur Erzeugung des Grundmagnetfeldes, eine Gradienteneinheit 5 zur Erzeugung der Gradientenfelder, eine Hochfrequenzeinheit 7 zur Einstrahlung und zum Empfang von Hochfrequenzsignalen und eine zur Durchführung eines erfindungsgemäßen Verfahrens ausgebildete Steuereinrichtung 9. In der Figur 8 sind diese Teileinheiten der Magnetresonanzanlage 1 nur grob schematisch dargestellt. Insbesondere kann die Hochfrequenzeinheit 7 aus mehreren Untereinheiten, beispielsweise aus mehreren Spulen wie den schematisch gezeigten Spulen 7.1 und 7.2 oder mehr Spulen bestehen, die entweder nur zum Senden von Hochfrequenzsignalen oder nur zum Empfangen der ausgelösten Hochfrequenzsignale oder für beides ausgestaltet sein können.

Zur Untersuchung eines Untersuchungsobjektes U, beispielsweise eines Patienten oder auch eines Phantoms, kann dieses auf einer Liege L in die Magnetresonanzanlage 1 in deren Messvolumen eingebracht werden. Die Schicht S stellt ein exemplarisches Zielvolumen des Untersuchungsobjekts dar, aus dem Messdaten aufgenommen werden können.

Die Steuereinrichtung 9 dient der Steuerung der Magnetresonanzanlage und kann insbesondere die Gradienteneinheit 5 mittels einer Gradientensteuerung 5' und die Hochfrequenzeinheit 7 mittels einer Hochfrequenz-Sende-/Empfangs-Steuerung 7' steuern. Die Hochfrequenzeinheit 7 kann hierbei mehrere Kanäle umfassen, auf denen Signale gesendet oder empfangen werden können.

Die Hochfrequenzeinheit 7 ist zusammen mit ihrer Hochfrequenz-Sende-/Empfangs-Steuerung 7` für die Erzeugung und das Einstrahlen (Senden) eines Hochfrequenz-Wechselfeldes zur Manipulation der Spins in einem zu manipulierenden Bereich (beispielsweise in zu messenden Schichten S) des Untersuchungsobjekts U zuständig. Dabei muss die Mittenfrequenz des, auch als B1-Feld bezeichneten, Hochfrequenz-Wechselfeldes nahe der Resonanzfrequenz der zu manipulierenden Spins liegen. Zur Erzeugung des B1-Feldes werden in der Hochfrequenzeinheit 7 mittels der Hochfrequenz-sende/empfangs-Steuerung 7' gesteuerte Ströme an den HF-Spulen angelegt.

Weiterhin umfasst die Steuereinrichtung 9 eine Fluktuierungseinheit 15, mit welcher k-Raum-Trajektorien fluktuiert und ggf. optimierte Rahmenbedingungen für die Fluktuation festgelegt werden können. Die Steuereinrichtung 9 ist insgesamt dazu ausgebildet, ein erfindungsgemäßes Verfahren zur Vermeidung von Artefakten bei der Akquisition von MR-Daten eines Untersuchungsobjekts durchzuführen.

Eine von der Steuereinrichtung 9 umfasste Recheneinheit 13 ist dazu ausgebildet alle für die nötigen Messungen und Bestimmungen nötigen Rechenoperationen auszuführen. Hierzu benötigte oder hierbei ermittelte Zwischenergebnisse und Ergebnisse können in einer Speichereinheit S der Steuereinrichtung 9 gespeichert werden. Die dargestellten Einheiten sind hierbei nicht unbedingt als physikalisch getrennte Einheiten zu verstehen, sondern stellen lediglich eine Untergliederung in Sinneinheiten dar, die aber auch z.B. in weniger oder auch in nur einer einzigen physikalischen Einheit realisiert sein können.

Über eine Ein-/Ausgabeeinrichtung E/A der Magnetresonanzanlage 1 können, z.B. durch einen Nutzer, Steuerbefehle an die Magnetresonanzanlage geleitet werden und/oder Ergebnisse der Steuereinrichtung 9 wie z.B. Bilddaten angezeigt werden.

Ein hierin beschriebenes Verfahren kann auch in Form eines Computerprogrammprodukts vorliegen, welches ein Programm umfasst und das beschriebene Verfahren auf einer Steuereinrichtung 9 implementiert, wenn es auf der Steuereinrichtung 9 ausgeführt wird. Ebenso kann ein elektronisch lesbarer Datenträger 26 mit darauf gespeicherten elektronisch lesbaren Steuerinformationen vorliegen, welche zumindest ein solches eben beschriebenes Computerprogrammprodukt umfassen und derart ausgestaltet sind, dass sie bei Verwendung des Datenträgers 26 in einer Steuereinrichtung 9 einer Magnetresonanzanlage 1 das beschriebene Verfahren durchführen.

## Patentansprüche

1. Magnetresonanz-Fingerprinting-Verfahren zur Erzeugung von Messdaten eines Untersuchungsobjektes, wobei das Verfahren die folgenden Schritte umfasst:
- Laden von Parametern, die eine Start-k-Raumtrajektorie (SkRt) beschreiben, entlang der Messdaten (MDS) aufgenommen werden sollen,
- Erstellen mindestens einer Mess-k-Raumtrajektorie (MkRt) durch Fluktuieren mindestens eines den Verlauf der Start-k-Raumtrajektorie (SkRt) bestimmenden Parameters, sodass die erstellte Mess-k-Raumtrajektorie (MkRt) erratisch verläuft,
- Aufnehmen von Messdaten (MDS) entlang der Mess-k-Raumtrajektorie (MkRt),
- Wiederholen der Aufnahme von Messdaten (MDS) entlang von erstellten Mess-k-Raumtrajektorien (MkRt) mit unterschiedlichen Fingerprinting-Parametern bis alle gewünschten Messdaten (MDS) aufgenommen sind,
- Speichern der aufgenommenen Messdaten (MDS) in einem Messdatensatz,
**dadurch gekennzeichnet, dass** das Fluktuieren derart erfolgt, dass eine räumliche und/oder zeitliche Verteilung des in den aufgenommenen Signalen enthaltenen Rauschens möglichst homogen ist.

2. Verfahren nach Anspruch 1, wobei das Fluktuieren durch zufällige Variation des den Verlauf der Start-k-Raumtrajektorie (SkRt) bestimmenden Parameters innerhalb vorgegebener Grenzwerte erfolgt.

3. Verfahren nach einem der vorhergehenden Ansprüche, wobei Messdaten (MDS) wiederholt in mindestens zwei Wiederholungen basierend auf einer Start-k-Raumtrajektorie (SkRt) aufgenommen werden, wobei für jede Wiederholung der Aufnahme der Messdaten (MDS) jeweils unterschiedliche Mess-k-Raumtrajektorien (MkRt) ausgehend von der Start-k-Raumtrajektorie (SkRt) erstellt werden.

4. Verfahren nach einem der Ansprüche 1 bis 2, wobei Parameter für mindestens zwei Start-k-Raumtrajektorien (SkRt) geladen werden zu denen jeweils genau eine Mess-k-Raumtrajektorie (MkRt) erstellt wird.

5. Verfahren nach einem der vorhergehenden Ansprüche, wobei eine Start-k-Raumtrajektorie (SkRt) allein den k-Raum gemäß Nyquist unterabtastet.

6. Verfahren nach einem der vorhergehenden Ansprüche, wobei die Start-k-Raumtrajektorie (SkRt) eine radiale oder spirale k-Raumtrajektorie ist und als Parameter der Startwinkel der Start-k-Raumtrajektorie (SkRt) fluktuiert wird.

7. Verfahren nach einem der vorhergehenden Ansprüche, wobei die Start-k-Raumtrajektorie (SkRt) eine spirale k-Raumtrajektorie ist und als Parameter der Radius der Start-k-Raumtrajektorie fluktuiert wird.

8. Verfahren zur Erstellung von Parameterkarten mittels Magnetresonanz-Fingerprinting, wobei bekannte charakteristische Signalverläufe mit mindestens einem aus einem gemäß einem Verfahren gemäß einem der Ansprüche 1 bis 7 erstellten Magnetresonanzdatensatz bestimmten Signalverlauf mindestens eines Bildpunkts verglichen wird, und wobei basierend auf Ergebnissen des Vergleichs dem mindestens einen Bildpunkt ein Parameterwert zugeordnet wird.

9. Magnetresonanzanlage (1) umfassend, eine Magneteinheit (3), eine Gradienteneinheit (5), eine Hochfrequenzeinheit (7) und eine Steuereinrichtung (9) mit einer Hochfrequenz-Sende-/Empfangs-Steuerung (7') und einer Fluktuierungseinheit (15), wobei die Steuereinrichtung (9) dazu ausgebildet ist, ein Verfahren nach einem der Ansprüche 1 bis 8 auf der Magnetresonanzanlage (1) auszuführen.

10. Computerprogramm, welches direkt in einen Speicher einer Steuereinrichtung (9) einer Magnetresonanzanlage (1) ladbar ist, mit Programm-Mitteln, um die Schritte des Verfahrens nach einem der Ansprüche 1 bis 8 auszuführen, wenn das Programm in der Steuereinrichtung (9) der Magnetresonanzanlage (1) ausgeführt wird.

11. Elektronisch lesbarer Datenträger mit darauf gespeicherten elektronisch lesbaren Steuerinformationen, welche zumindest ein Computerprogramm nach Anspruch 10 umfassen und derart ausgestaltet sind, dass sie bei Verwendung des Datenträgers in einer Steuereinrichtung (9) einer Magnetresonanzanlage (1) ein Verfahren nach einem der Ansprüche 1 bis 8 durchführen.

## Claims

1. Magnetic resonance fingerprinting method for generating measurement data of an examination object, wherein the method comprises the following steps:
- loading of parameters which describe a starting k-space trajectory (SkRt) along which measurement data (MDS) is to be recorded,
- creation of at least one measurement k-space trajectory (MkRt) by means of fluctuation of at least one of the parameters determining the course of the starting k-space trajectory (SkRt), so that the created measurement k-space trajectory (MkRt) runs erratically,
- recording of measurement data (MDS) along the measurement k-space trajectory (MkRt),
- repetition of the recording of measurement data (MDS) along created measurement k-space trajectories (MkRt) using different fingerprinting parameters until all the desired measurement data (MDS) has been recorded,
- storage of the recorded measurement data (MDS) in a measurement dataset,
**characterised in that**
fluctuation takes place such that a spatial and/or temporal distribution of the noise contained in the recorded signals is as homogenous as possible.

2. Method according to claim 1, wherein fluctuation takes place by means of random variation of the parameter determining the course of the starting k-space trajectory (SkRt) within predefined limit values.

3. Method according to one of the preceding claims, wherein measurement data (MDS) is recorded repeatedly in at least two repetitions based on a starting k-space trajectory (SkRt), wherein for each repetition of the recording of the measurement data (MDS), in each case different measurement k-space trajectories (MkRt) starting from the starting k-space trajectory (SkRt) are created.

4. Method according to one of claims 1 to 2, wherein parameters for at least two starting k-space trajectories (SkRt) are loaded for which precisely one measurement k-space trajectory (MkRt) is created in each case.

5. Method according to one of the preceding claims, wherein a starting k-space trajectory (SkRt) only subsamples k-space according to Nyquist.

6. Method according to one of the preceding claims, wherein the starting k-space trajectory (SkRt) is a radial or spiral k-space trajectory and is fluctuated as a parameter of the starting angle of the starting k-space trajectory (SkRt).

7. Method according to one of the preceding claims, wherein the starting k-space trajectory (SkRt) is a spiral k-space trajectory and is fluctuated as a parameter of the radius of the starting k-space trajectory.

8. Method for generating parameter maps by means of magnet resonance fingerprinting, wherein known characteristic signal waveforms are compared with at least one signal waveform determined from a magnetic resonance data set produced according to a method according to one of claims 1 to 7 of at least one pixel, and wherein based on results of the comparison, a parameter value is assigned to at least one pixel.

9. Magnetic resonance system (1) comprising a magnet unit (3), a gradient unit (5), a radio frequency unit (7) and a control device (9) with a radio frequency transmit/receive controller (7`) and a fluctuation unit (15), wherein the control device (9) is designed to perform a method according to one of claims 1 to 8 on the magnetic resonance system (1).

10. Computer program which can be loaded directly into a storage device of a control device (9) of a magnetic resonance system (1), with program resources to perform the steps of the method according to one of claims 1 to 8 when the program is performed in the control device (9) of the magnetic resonance system (1).

11. Electronically readable data carrier with electronically readable control information stored thereon, comprising at least one computer program according to claim 10 and embodied in such a way that it performs a method according to one of claims 1 to 8 when using the data carrier in a control device (9) of a magnetic resonance system (1).

## Revendications

1. Procédé de prise d'empreintes digitales par résonnance magnétique pour la production de données de mesure d'un objet à examiner, dans lequel le procédé comprend les stades suivants :
- charge de paramètres, qui décrivent une trajectoire (SkRt) dans l'espace k de début le long de laquelle des données (MDS) de mesure doivent être enregistrées,
- établissement d'au moins une trajectoire (MkRt) dans l'espace k de mesure par fluctuation d'au moins un paramètre déterminant le tracé de la trajectoire (SkRt) dans l'espace k de début, de manière à ce que la trajectoire (MkRt) établie dans l'espace k de mesure s'étende d'une manière erratique,
- enregistrement de données (MDS) de mesure le long de la trajectoire (MkRt) dans l'espace k de mesure,
- répétition de l'enregistrement de données (MDS) de mesure le long de trajectoires (MkRt) établies dans l'espace k de mesure avec des paramètres de prise d'empreintes digitales différents jusqu'à ce que toutes les données (MDS) de mesure souhaitées soient enregistrées,
- mise en mémoire des données (MDS) de mesure enregistrées en un ensemble de données de mesure,
**caractérisé en ce que**
la fluctuation s'effectue de manière à ce qu'une répartition spatiale et/ou temporelle du bruit contenu dans les signaux enregistrés soit homogène le plus possible.

2. Procédé suivant la revendication 1, dans lequel la fluctuation s'effectue par des variations aléatoires à l'intérieur de valeurs limites données à l'avance du paramètre déterminant le tracé de la trajectoire (SkRt) dans l'espace k de début.

3. Procédé suivant l'une des revendications précédentes, dans lequel on enregistre des données (MDS) de mesure de manière répétée en au moins deux répétitions sur la base d'une trajectoire (SkRt) dans l'espace k de début, dans lequel, pour chaque répétition, on établit l'enregistrement des données (MDS) de mesure respectivement de trajectoires (MkRt) dans l'espace k de mesure différentes, à partir de la trajectoire (SkRt) dans l'espace k de début.

4. Procédé suivant l'une des revendications 1 à 2, dans lequel on charge des paramètres pour au moins deux trajectoires (SkRt) dans l'espace k de début, pour lesquelles on établit respectivement exactement une trajectoire (MkRt) dans l'espace k de mesure.

5. Procédé suivant l'une des revendications précédentes, dans lequel une trajectoire (SkRt) dans l'espace de début sous-échantillonne à soi seule l'espace k suivant Nyquist.

6. Procédé suivant l'une des revendications précédentes, dans lequel la trajectoire (SkRt) dans l'espace k de début et d'une trajectoire dans l'espace k radiale ou spirale et on fait fluctuer, comme paramètre, l'angle de début de la trajectoire (SkRt) dans l'espace k de début.

7. Procédé suivant l'une des revendications précédentes, dans lequel la trajectoire (SkRt) dans l'espace k de début est une trajectoire dans l'espace k spiral et on fait fluctuer, comme paramètre, le rayon de la trajectoire dans l'espace k de début.

8. Procédé d'établissement de cartes de paramètre au moyen d'une prise d'empreintes digitales par résonnance magnétique, dans lequel on compare des tracés de signal caractéristiques connus à au moins un tracé de signal d'au moins un point image, déterminé à partir d'un ensemble de données de résonnance magnétique établi selon un procédé suivant l'une des revendications 1 à 7, et dans lequel, sur la base des résultats de la comparaison, on affecte une valeur de paramètre au au moins un point image.

9. Installation (1) de résonnance magnétique comprenant une unité (3) d'aimant, une unité (5) de gradient, une unité (7) de haute fréquence et un dispositif (9) de commande ayant une commande (7') d'émission/réception de haute fréquence et une unité (15) de fluctuation, dans laquelle le dispositif (9) de commande est constitué pour exécuter un procédé suivant l'une des revendications 1 à 8 sur l'installation (1) de résonnance magnétique.

10. Programme d'ordinateur, qui peut être chargé directement dans la mémoire d'un dispositif (9) de commande d'une installation (1) de résonnance magnétique, comprenant des moyens de programme pour exécuter les stades du procédé suivant l'une des revendications 1 à 8, lorsque le programme est exécuté dans le dispositif (9) de commande de l'installation (1) de résonnance magnétique.

11. Support de données, déchiffrable électroniquement, ayant des informations de commande, déchiffrables électroniquement, qui sont mises en mémoire et qui comprennent au moins un programme d'ordinateur suivant la revendication 10 et qui sont conformées de manière à ce qu'elles exécutent, lors de l'utilisation du support de données dans un dispositif (9) de commande d'une installation (1) de résonnance magnétique, un procédé suivant l'une des revendications 1 à 8.
